# EUROPEAN PATENT APPLICATION

(11) **EP 1 296 422 A2**
(43) Date of publication of application: **26.03.2003**
(21) Application number: 02255403.4
(22) Date of filing: 01.08.2002
(51) Int. Cl.: H01R 43/28

(54) **Flex cable**

(30) Priority: 25.09.2001 US 963227
(71) Applicant: Hewlett-Packard Company, Palo Alto, CA 94304 (US)
(72) Inventor: Reasoner, Kelly J., Fort Collins, CO 80526 (US); Frey, Lyle D., Loveland, CO 80538-2153 (US)
(74) Representative: Jehan, Robert

(57) **Abstract**

A method of connecting a flex cable, includes the steps of bending the flex cable (5) beyond a non-zero preset angle in the flex cable, without folding the flex cable, and connecting the bent flex cable. A method and apparatus that reduces flaring in a flex cable.

## Description

The present invention relates generally to flexible cables and preferably to a method and device for reducing the flare in the flexible cable.

Flex cables, flexible circuits, flex harnesses, and flexible printed wiring are all names for electronic traces embedded in a flexible non-conductive material. Ribbon cables are typically multiple wires connected by their edges to form a strip of wires. Both flex circuits and ribbon cables are used to route electronic signals. In this patent specification the term flex cable will be construed to cover both flex circuits and ribbon cables.

Many devices currently use flex cables to connect different electronic components. In some devices the flex cables turn corners to connect devices that are not co-linear. Some of these devices contain moving parts. When flex cables are attached to the moving parts or are near a moving part, care must be taken to ensure that the flex cable is not caught by the relative motion between the parts. If the flex cable is caught by a moving part the flex cable can be torn or damaged. Flex cables that turn comers have a higher likelihood of getting caught than flex cables that run in straight lines. Typically the flex cables that turn comers get caught on the outer radius of the bend that forms the comer. The tendency of a flex cable that has a comer or bend in it to stick up is called flaring.

One of the current solutions to this flaring problem is to attach a piece of double-sided tape under the flex cable to help hold the comer of the flex cable down. Unfortunately, double-sided tape is an additional part and does not work well in some environments.

The present invention seeks to provide improved cabling.

According to an aspect of the present invention, there is provided a method of connecting a flex cable as specified in claim 1.

According to another aspect of the present invention, there is provided a method of connecting a flex cable to a movable picker as specified in claim 4.

According to another aspect of the present invention, there is provided a method of connecting a flex cable as specified in claim 5.

According to another aspect of the present invention, there is provided a method of producing a flex cable as specified in claim 6.

According to another aspect of the present invention, there is provided an assembly as specified in claim 9.

The preferred embodiment can provide a method and apparatus that reduces the flaring in flex cables without double-sided tape.

Embodiments of the present invention are described below, by way of example only, with reference to the accompanying drawings, in which:
Figure 1 is a perspective view of a prior art flex cable attached to a device having relative motion between parts;
Figure 2 is a drawing of a flex cable with a 90 preset angle;
Figure 3 is a drawing of an embodiment of flex cable with a preset angle of 102 degrees;
Figure 4 is a perspective view of an embodiment of flex cable attached to a device having relative motion between parts;
Figure 5 is a perspective view of an embodiment of flex cable shown in its bent condition;
Figure 6 is a drawing of an embodiment of flex cable with a preset angle of 78 degrees; and
Figure 7 is a perspective view of an embodiment of flex cable with a required angle less than 90 degrees.

A method and apparatus that reduces flaring in a flex cable without double-sided tape can reduce the number of parts required for the assembly.

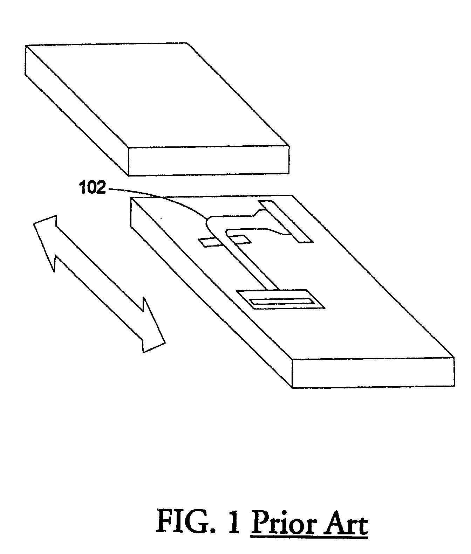

Auto-changers are typically large storage devices that contain many individual storage mediums, for example tapes, or RWCD's or DVD's. In this application a tape auto-changer will be used as an example but any type of storage medium could be used. In a tape auto-changer the tapes are typically kept in an array of racks and a picker is typically used to retrieve a tape and move it to one of the tape drives in the auto-changer. The picker typically has a number of electronic components attached to the picker. Some of these components may be connected using flex cables. As a result of the tight tolerances between the picker and the auto-changer, any flex cable used on the outer surface of the picker is in danger of being damaged if it lifts away from the outer surface. Typically, flex cables that run in a straight line do not lift away from the surface. However, flex cables that turn corners do have a tendency to lift away from the outer surface of the picker. This tendency to flare is dependent on the installation of the flex cable and can vary from assembly to assembly. Typically the flex cables flare or lift away from the surface at the outer radius of the comer (see 102). This flaring can cause the flex cable to be caught and damaged when the picker moves relative to the auto-changer body (see Figure 1).

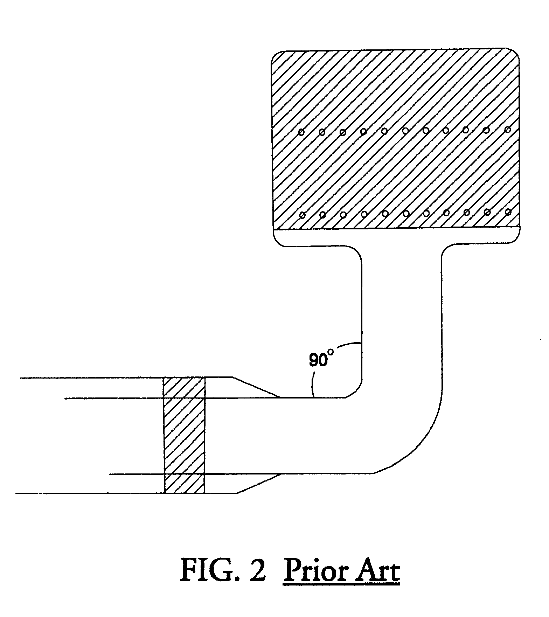

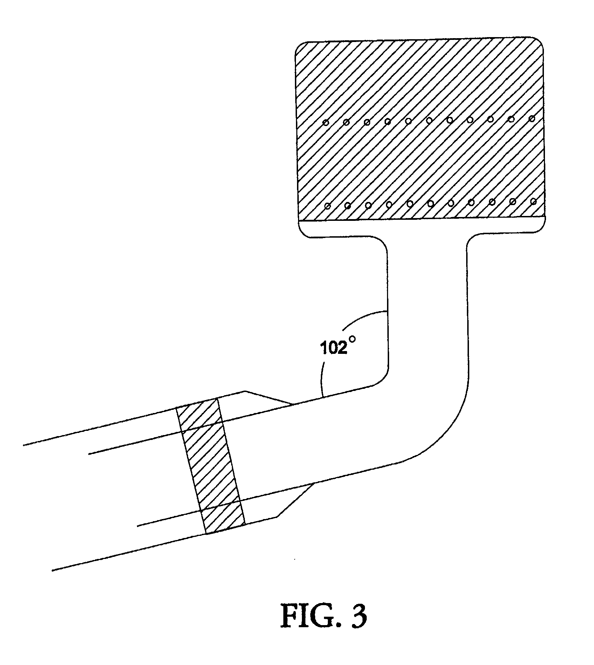

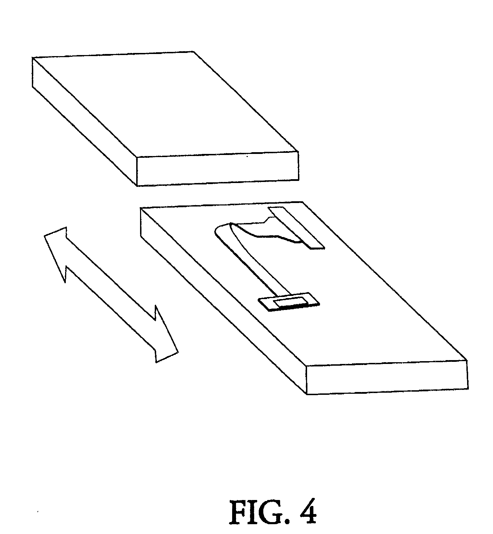

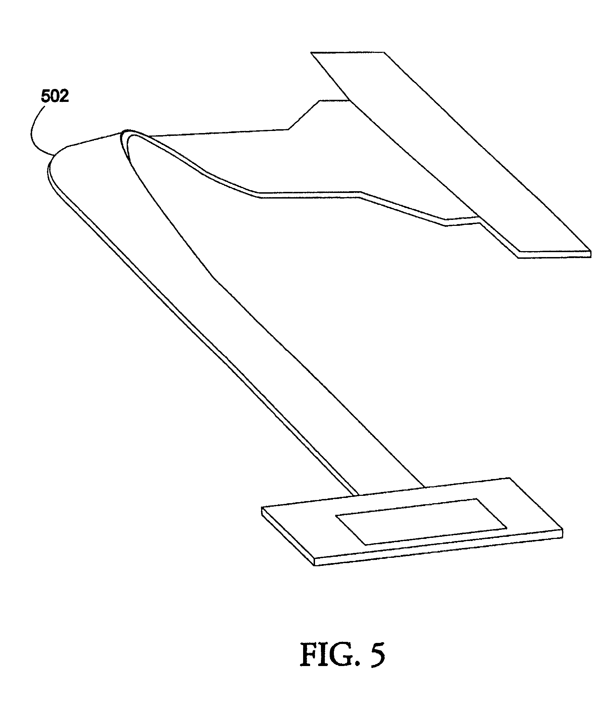

Figure 2 shows an example flex cable with a preset angle forming a 90-degree comer. Figure 3 shows an example embodiment flex cable which has been modified from the flex cable in Figure 2 by changing the preset angle from 90 degrees to 102 degrees, a 12-degree change in the preset angle. The required angle between the components connected by the flex cable has not changed and is still 90 degrees. The preset angle in the flex cable has been changed to something other than the required angle. In actual use the flex cable with the preset angle of 102 degrees is bent to form a 90-degree comer and then connected in its bent condition (see Figure 4). By bending the flex cable beyond its preset angle, the outer radius of the comer 502 is forced downward and out of the plane formed by the flex cable in its relaxed condition (see Figure 5). By forcing the outer radius down towards the picker, the flex cable in this embodiment has reduced the tendency to flare in the flex cable.

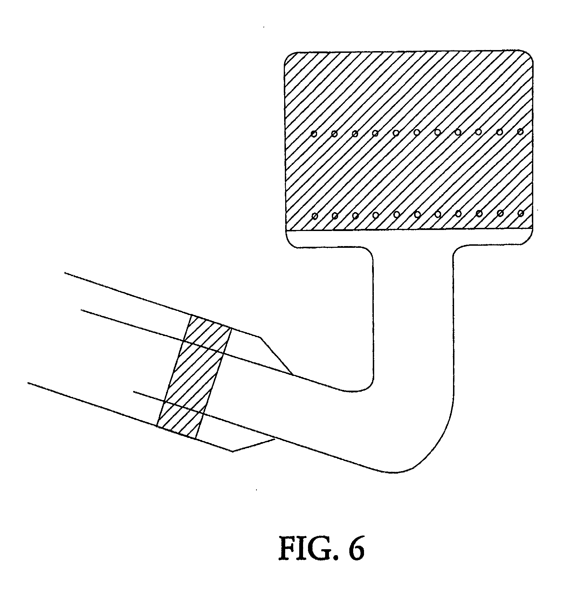

A 12-degree change in the preset angle forming the comer of the flex cable is the preferred embodiment of the present invention. However, a wide range of angle changes will also work. Increasing the preset angle from the required angle also constitutes a preferred embodiment of the invention, for example increasing the angle from 90-degrees to 102-degrees. However, a decrease in preset angle will also work, for example decreasing the preset angle from 90-degrees to 78-degrees (see Figure 6). When the preset angle is decreased, the flex cable is bent beyond the preset angle in the opposite direction during use.

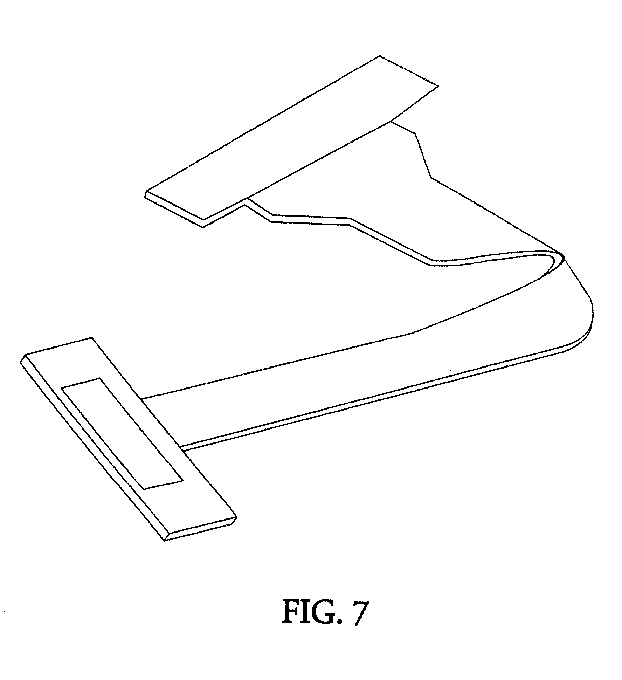

In the above examples, the required angle forming the comer in the flex cable was 90-degrees. The described embodiments are not limited to required angles of 90-degrees, but will work over a wide range of required angles (see Figure 7). For example the required angle could be anywhere between almost zero to almost 180-degrees.

In the above examples a picker in an auto-changer was used to illustrate parts containing flex cables that have relative motion. The current invention is not limited to auto-changer but will be effective for flex cables used in any devices. The current invention is not limited to flex cables on parts having relative motion. Using the current invention can ease the assembly of devices that do not have relative motion. By reducing the flare in the flex cables, the current invention can minimise damage to flex cables during the assembly of a device that has no relative motion during actual use.

The foregoing description of the present invention has been presented for purposes of illustration and description. It is not intended to be exhaustive or to limit the invention to the precise form disclosed, and other modifications and variations may be possible in light of the above teachings. The embodiment was chosen and described in order to clearly explain the principles of the invention. It is intended that the appended claims be construed to include other alternative embodiments of the invention.

The disclosures in United States patent application no. 09/963,227, from which this application claims priority, and in the abstract accompanying this application are incorporated herein by reference.

## Claims

1. A method of connecting a flex cable, including the steps of:
bending the flex cable (5) beyond a non-zero preset angle in the flex cable, without folding the flex cable, and
connecting the bent flex cable.

2. A method as in claim 1, wherein the flex cable is bent approximately 12 degrees beyond its preset angle.

3. A method as in claim 1 or 2, where the flex cable forms approximately a 90 degrees angle after it has been connected.

4. A method of connecting a flex cable on a movable picker, including the steps of:
bending the flex cable (4) past a preset angle in the flex cable, without folding the flex cable, and
connecting the bent flex cable to the movable picker, whereby an outer radius of the preset angle is bent towards the movable picker.

5. A method of connecting a flex cable, including the step of:
forming a curve in an inner radius of a bend in the flex cable, without folding the flex cable, whereby an outer radius (502) of the bend in the flex cable is forced out of the plane defined by a first end and a second end of the flex cable, and
connecting the flex cable while maintaining the curved condition.

6. A method of producing a flex cable, including the steps of:
determining the required angle for a comer in the flex cable; fabricating a flex cable with a comer in the flex cable with an different angle than the required angle.

7. A method as in claim 6, wherein the angle is different by approximately 12 degrees.

8. A method as in claim 6 or 7, wherein the fabricated angle is larger than the required angle.

9. An assembly, including:
a movable device with a first surface;
a flex cable with a first end and a second end, the first end forming a preset angle with respect to the second end, the preset angle being in a plane whereby the first end and the second ends are in a common plane, the preset angle forming an outer radius in the flex cable;
the first end and the second end of the flex cable being attached to the first surface of the movable device, wherein in the attached state the first end of the flex cable forms an angle with respect to the second end of the flex cable that is different from the preset angle, whereby the outer radius of the flex cable is directed towards the first surface of the movable device.

10. An assembly as in claim 9, where the difference in the preset angle and the attached angle is between the range of 4 and 20 degrees.
